# EUROPEAN PATENT APPLICATION

(11) **EP 4 475 333 A1**
(43) Date of publication of application: **11.12.2024**
(21) Application number: 23215368.4
(22) Date of filing: 08.12.2023
(51) Int. Cl.: H01Q 1/22, H01Q 1/40, H01Q 9/42, H01Q 11/08, H01Q 5/335

(54) **APPARATUS AND METHODS FOR INVERTED-L AND INVERTED-F ANTENNAS**

(30) Priority: 05.06.2023 US 202363506203 P; 31.10.2023 US 202318498523
(71) Applicant: Analog Devices International Unlimited Company, Limerick (IE)
(72) Inventor: OCUNCHUBHAIR, Oisin, Co. Limerick (IE)
(74) Representative: Yang, Shu

(57) **Abstract**

There is provided a printed antenna, comprising a first conductive layer patterned to form two or more metal regions of a radiating element; a second conductive layer patterned to form at least one metal region of the radiating element, wherein the first conductive layer and the second conductive layer are separated by a dielectric; and a plurality of vias connecting the two or more metal regions on the first conductive layer to the at least one metal region on the second conductive layer to form a coil. There is also provide a wireless battery management system comprising the printed antenna and a method of forming a printed antenna thereof.

## Description

The present application claims priority to U.S. Provisional Patent Application No. 63/506203, filed June 5, 2023, and titled "APPARATUS AND METHODS FOR INVERTED-L AND INVERTED-F ANTENNAS" and to U.S. Non-Provisional Patent Application No. 18/498,523, filed October 31, 2023, and titled " APPARATUS AND METHODS FOR INVERTED-L AND INVERTED-F ANTENNAS".

### FIELD

This application relates to antennas and, in particular but not exclusively, to printed inverted-L and inverted-F antennas using dielectric loading and/or current vector alignment to reduce antenna footprint.

### BACKGROUND

In order to radiate effectively at a target operating frequency, a radiating antenna element should be of a sufficient length above the ground plane. When the radiating antenna element is implemented as a monopole antenna formed as a straight conductor, the resulting antenna structure may be too tall and/or large for many applications. To overcome this limitation, a 90-degree bend can be included in the monopole antenna to thereby form an inverted-L antenna with a reduced antenna footprint compared with the monopole antenna. Although an inverted-L antenna achieves reduced height above the ground plane, the bend in the inverted-L antenna may impact the impedance matching of the antenna. To address the impedance matching issue, an impedance tuning stub can be added to the structure to thereby form an inverted-F antenna.

To further reduce the antenna footprint, the radiating antenna element can be meandered. While the antenna footprint can be reduced by this technique, meandering the radiating antenna element may create opposing currents that decrease the antenna's effective length and thus increase the antenna's resonant frequency. Accordingly, an increase in the length of the radiating element is needed to return the antenna to its target operating frequency. Therefore, inverted-L and inverted-F antennas having improved performance alongside smaller antenna footprints are desirable.

### SUMMARY OF THE DISCLOSURE

A monopole antenna typically has a radiating element and a ground plane that are electrically connected to a receiver and/or transmitter. The printed antenna of the present disclosure has a first conductive layer patterned to form two or more metal regions of a radiating element, and a second conductive layer patterned to form at least one metal region of the radiating element, wherein the first conductive layer and the second conductive layer are separated by a dielectric. The antenna of the present disclosure also has a plurality of vias connecting the two or more metal regions on the first conductive layer to the at least one metal region on the second conductive layer to form a coil. Thus, in its simplest form, the radiating element of a printed antenna of the present disclosure has a coil formed of a metal region on the first conductive layer - via - metal region on the second conductive layer - via - metal region on the first conductive layer.

The present disclosure relates in particular to printed inverted-L and inverted-F antennas whereby the radiating element is formed over two conductive layers instead of one conductive layer, and through-hole vias connect the two conductive layers so as to enable the radiating conductor element to coil through the substrate between the top and bottom conductive layers.

The coiled structure allows for a reduction In antenna footprint compared with meandered printed antennas used in wireless battery management systems, where space is limited. The effective length of the antenna is increased by utilizing current vector alignment along the elements on each conductive layer. In this coiled configuration, a shorter radiating element length can be used to maintain the resonant frequency. This represents an improvement over certain conventional meandered printed antennas in which the current vectors oppose, thus requiring elongation of the radiating element to maintain the desired resonant frequency.

The coiled structure also reduces the level of detuning normally associated with locating antennas near conductive surfaces. This is particularly advantageous in the context of wireless battery management systems, which have many conductive surfaces that could act to detune the antenna once it is placed within the system.

In a first aspect, there is provided a printed antenna, comprising: a first conductive layer patterned to form two or more metal regions of a radiating element; a second conductive layer patterned to form at least one metal region of the radiating element, wherein the first conductive layer and the second conductive layer are separated by a dielectric; and a plurality of vias connecting the two or more metal regions on the first conductive layer to the at least one metal region on the second conductive layer to form a coil.

In a second aspect, there is provided a wireless battery management system comprising: a battery module; and a printed antenna according to the first aspect.

In a third aspect, there is provided a method of forming a printed antenna, the method comprising: patterning a first conductive layer of a printed circuit board, PCB, to form two or more metal regions of a radiating element; patterning a second conductive layer of the PCB to form at least one metal region of the radiating element, wherein the first conductive layer and the second conductive layer are separated by dielectric; and forming a plurality of vias connecting the two or more metal regions on the first conductive layer to the at least one metal region on the second conductive layer to form a coil.

### Definitions

An antenna may act as a transceiver that receives and/or transmits electromagnetic waves and it may also act as a transducer to convert the electromagnetic waves into electrical currents during reception, or electrical currents into electromagnetic waves during transmission. The electromagnetic waves that an antenna transmits and receives may be radio waves, microwaves, infrared radiation, or visible light. In the present disclosure, the electromagnetic waves are typically microwaves.

A chip antenna may have a ceramic dielectric-filled cavity in between two conductors. Advantages of chip antennas include greater interference resilience and smaller sizes compared with printed antennas. However, chip antennas are more expensive and may have lower performance compared with printed antennas.

A printed antenna, otherwise known as a microstrip antenna, may be fabricated using photolithographic techniques on a PCB and comprise conductor traces in various patterns, such as inverted-L, inverted-F and meandered shapes, on a dielectric layer. Advantages of printed antennas include higher bandwidths and higher reliability compared with chip antennas. However printed antennas may be more sensitive to interference and have a larger footprint area compared with chip antennas. The term 'printed antenna' may be used interchangeably with 'printed circuit board antenna'.

The footprint of an antenna may be defined as the space it occupies. For example, in a printed antenna, the antenna footprint may be the dimensions that the antenna components take up on the PCB.

The resonant frequency of an antenna refers to when the received electromagnetic waves or the transmitted electromagnetic wave has the highest amplitude or, in other words, when power is highest. This can occurs when capacitive reactance and inductive reactance are equal to one another. It is at least dependent upon the length of the radiating element, the impedance and impedance bandwidth, and the dielectric loading of the antenna.

Antenna impedance is the input impedance measured at the terminals of an antenna. Impedance matching of the antenna with the output circuit is important so as to ensure optimum power transfer in the system. For radio frequency systems, characteristic impedance may be around 50 Ohms.

Antenna impedance bandwidth is the frequency band over which the antenna has good impedance matching. For example, the antenna impedance bandwidth may be defined by a range of frequencies in which the antenna impedance magnitude falls below half of its resonant frequency.

Dielectric loading of an antenna refers to the dielectric constant of the dielectric material used in the antenna, which may affect the radiation pattern and impedance bandwidth of the antenna. For example, the dielectric constant of a dielectric substrate used in a printed antenna may range of 2.2 ≤ εr ≤ 12. Increasing the dielectric constant of the material(s) used in an antenna may increase dielectric loading of the radiating element, which may decrease the resonant frequency of the radiating element for a fixed radiating element length.

Current vector alignment increases the effective length of an antenna. When current vectors oppose, the resonant frequency of the antenna may increase for a given radiation element length, thus requiring elongation of the radiating element to maintain the desired resonant frequency. However, when more current vectors are aligned, the resonant frequency of the antenna may be lowered for a given radiation element length, thus the radiating element length can be shorter to maintain the desired resonant frequency.

### FIGURES

Aspects of the present disclosure are described, by way of example only, with reference to the following drawings, in which:
Figure 1 illustrates schematic representations of meandered inverted-L and inverted-F antennas;
Figure 2 illustrates schematic representations of inverted-L and inverted-F antennas in accordance with an aspect of the present disclosure;
Figure 3 is a top and bottom layer view of an inverted-L antenna in accordance with an aspect of the present disclosure;
Figure 4 is a top and bottom layer view of an inverted-F antenna in accordance with an aspect of the present disclosure;
Figure 5 is a side view of an inverted-L antenna in accordance with an aspect of the present disclosure;
Figure 6 is a side view of an inverted-F antenna in accordance with an aspect of the present disclosure;
Figure 7 illustrates magnetic field distribution vectors generated around the conductors of both meandered and coiled antenna structures;
Figure 8 is an example graph of the reflection coefficient for different antenna configurations in accordance with an aspect of the present disclosure;
Figure 9 is an example graph of the reflection coefficient for different dielectrics in accordance with an aspect of the present disclosure;
Figure 10 is an example graph of the reflection coefficient for internal and external conductor configurations in accordance with an aspect of the present disclosure;
Figure 11 shows example graphs of the real and imaginary impedance of different antennas; and
Figure 12 represents example method steps according to an aspect of the present disclosure.

### DETAILED DESCRIPTION

An antenna can receive and/or transmit electromagnetic waves and it can also convert the electromagnetic waves into electrical currents, and vice versa. In a typical antenna, conductive elements form a radiating element that receives or transmits electromagnetic waves in a particular radiation pattern.

Chip antennas are commonly used in the automotive industry in wireless battery management systems. However, aspects of the present disclosure relate to printed antennas that offer improved performance alongside lower cost.

As described in the background section, inverted-L and inverted-F antennas can reduce antenna footprint compared with monopole antennas, for example, by reducing height above the ground plane. The present inventors have realised that instead of patterning on a single conductive layer in printed inverted-L and inverted-F antennas, patterning on at least two conductive layers can improve dielectric loading and/or current vector alignment of the antenna in order to reduce its footprint even further. The way in which the present disclosure achieves this effect is by virtue of the dielectric between the at least two conductive layers reducing the resonant frequency and by virtue of the arrangement of the two or more metal regions on the first conductive layer being substantially parallel such that a current vector of the printed antenna along the two or more metal regions on the first conductive layer is aligned promoting coupling between the regions, and the one region on the other conductive layer separated by a dielectric that is not substantially in parallel experiences reduced coupling to the regions on the first conductive layer and so does not affect the current vector alignment on the first conductive layer. Together, the combined effect of improved dielectric loading and increased current vector alignment result in a smaller antenna footprint.

Such a printed antenna of present disclosure may be particularly relevant in several applications, for example, in wireless battery management systems. Automotive wireless battery management systems may provide highly reliable and low latency solutions including robust connectivity for the battery cells. Radio nodes may need to be placed on each battery module to monitor the battery cells. Space is limited within automotive battery packs as maximising energy density is a priority. Therefore, the printed antenna of the present disclosure, which has a small antenna footprint, is particularly advantageous.

The battery packs also usually contain many metallic objects enclosed in a metallic case. Locating antennas in close proximity to conductive elements results in a significant impact on input impedance and detuning of the antenna. Therefore, the printed antenna of the present disclosure, which has increased dielectric loading of the radiating element to decrease the resonant frequency for a fixed radiating element length, is particularly advantageous.

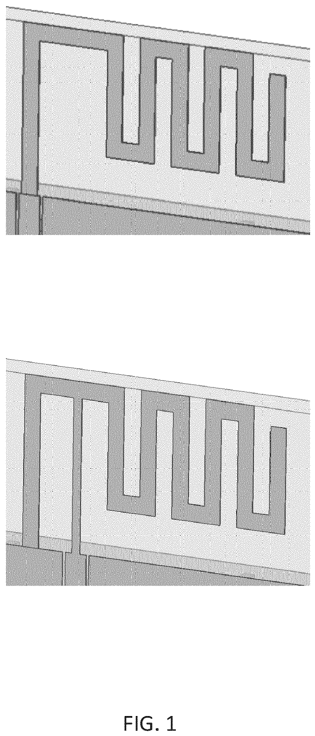

Figure 1 illustrates schematic representations of meandered inverted-L (top) and inverted-F (bottom) antennas. While antenna footprint can be reduced by this technique, meandering the radiating antenna element creates opposing currents along adjacent meander lengths that decreases the antenna's effective length and thus increase the antenna's resonant frequency due to magnetic field cancellation. Meandering may also affect the reflection coefficient, gain and impedance bandwidth of the printed antenna in detrimental ways.

In examples, the radiating element length of the meandered inverted-F antenna could be 37.3mm and its footprint could be 6x10mm.

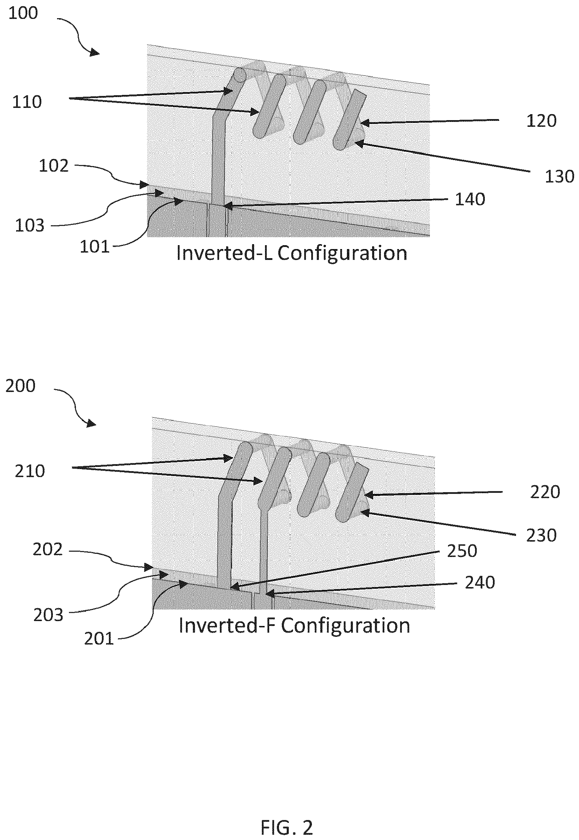

The present disclosure may work with printed inverted-L and inverted-F antennas. These two types of printed antennas will now be described in relation to Figures 2 to 6 with various schematic representations, top, bottom and sides views.

Figure 2 illustrates schematic representations of inverted-L (top) and inverted-F (middle and bottom) antennas in accordance with an aspect of the present disclosure, which could be implemented in a printed circuit board, PCB. The printed antenna 100, 200 has a first conductive layer 101, 201 and a second conductive layer 102, 202, the first conductive layer and the second conductive layer being separated by a dielectric 103, 203. These conductive layers may be patterned using, for example, copper metallization. The first conductive layer 101, 201 is patterned to form two or more metal regions 110, 210 of a radiating element, and the second conductive layer 102, 202 is patterned to form at least one metal regions 120, 220 of the radiating element in each of the examples of the present disclosure. In Figure 2, the first conductive layer 101, 201 is shown to be patterned to form four metal regions 110, 210 of a radiating element, and the second conductive layer 102, 202 is patterned to form three metal regions 120, 220 of the radiating element.

As can be seen, the two or more metal regions 110, 210 on the first conductive layer 101, 201 are arranged at an angle relative to the at least one region 120, 220 on the second conductive layer 102, 202. In preferred examples, the two or more metal regions 120, 220 on the first conductive layer 102, 202 are arranged substantially in parallel with one another. Additionally or alternatively, the two or more metal regions 120, 220 on the first conductive layer 102, 202 are arranged such that current vectors of the printed antenna along the two or more metal regions on the first conductive layer are aligned.

Although only two conductive layers are shown in Figure 2, it will be appreciated that more conductive layers are covered by the present disclosure. In the event that the printed antenna has further conductive layers, the metal regions on those further conductive layers may also be arranged substantially in parallel with one another. Since each conductive layer is separated by dielectric and the metal regions on one conductive layer are not substantially parallel to the metal regions on a second layer, the metal regions on one conductive layer have negligible impact on the current vector alignment on the other conductive layers.

In Figure 2, vias 130, 230 are shown to enable the radiating element to coil through the substrate, providing an electrical connection between the first conductive layer 101, 201 and the second conductive layer 102, 202. Vias 130, 230 may be through-hole vias. The coiled structure allows for a reduction in antenna footprint compared to meandered printed antennas used in wireless battery management systems. Thus, the effective length of the antenna is increased by utilizing current vector alignment along the elements on each conductive layer. In this configuration, a shorter radiating element length is required to maintain the resonant frequency. This is an improvement over conventional meandered printed antennas where the currents oppose thus requiring elongation of the radiating element to maintain the resonant frequency. The coiled structure also reduces the level of detuning normally associated with locating antennas near conductive surfaces.

The two or more metal regions 120, 220 on the first conductive layer 101, 201 includes a first metal region electrically coupled to a radio frequency, RF, signal feed 140, 240 for the printed antenna. The signal feed 140 is electrically coupled to the start of the radiating element forming the inverted-L antenna. The signal feed 240 is electrically coupled further along the radiating element to achieve a more efficient input impedance and the start of the radiating element 250 is connected to the first conductive layer to form the inverted-F antenna.

The dielectric material 103, 203 separating the first conductive layer 101, 201 and the second conductive layer 102, 202 may comprise any dielectric material such as a glass-epoxy resin such as FR4 or a ceramic. The dielectric 103, 203 separating the first conductive layer 101, 201 and the second conductive layer 102, 202 may be configured to reduce a resonant frequency of the printed antenna as the velocity of propagation in a medium is reduced as the dielectric constant increases. This means that a fixed length conductive element will radiate at a lower frequency as the dielectrics relative permittivity increases when compared to air or that a resonant frequency can be achieved with a shorter conductive element.

In the examples of Figure 2, the radiating element length of the coiled inverted-L antenna or the inverted-F antenna could be 28.8mm and its footprint could be 6x6.3mm.

In the printed antennas 100, 200 of Figure 2, at least one of the first conductive layer 101, 201 and the second conductive layer 102, 202 may be an outermost layer. Further, at least one of the first conductive layer 101, 201 and the second conductive layer 102, 202 may be an internal conductive layer of the printed antenna. One of the first conductive layer 101, 201 and the second conductive layer 102, 202 may be an outermost conductive layer of the printed antenna and the other of the first conductive layer 101, 201 and the second conductive layer 102, 202 may be an internal conductive layer of the printed antenna 100,200.

The printed antennas 100, 200 in the examples of Figures 2 may be configured to be implemented in a battery module of a wireless battery management system and provide the advantages discussed above.

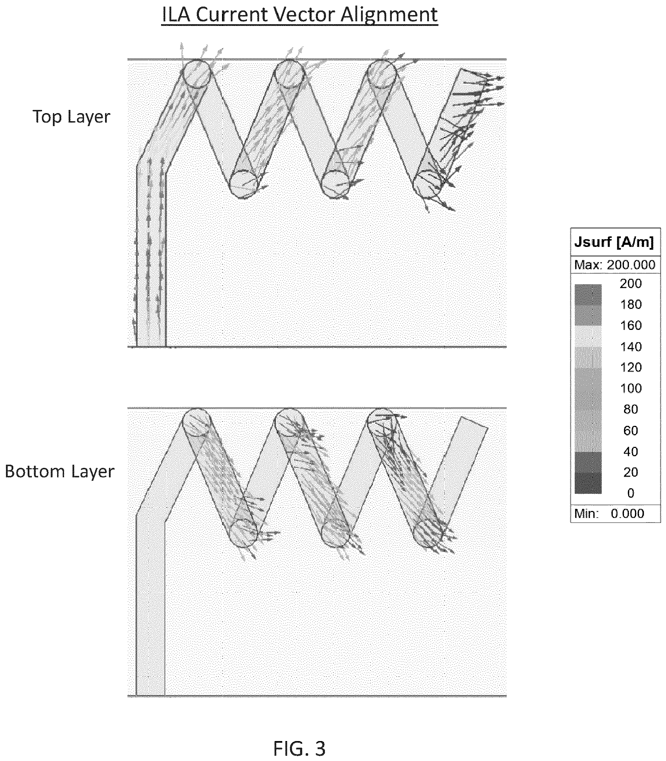

Figure 3 is a top and bottom layer view of an inverted-L antenna in accordance with an aspect of the present disclosure. The top layer view shows the first conductive layer 101 in more detail and the bottom layer view shows the second conductive layer 102 in more detail, in particular, illustrating the current vector alignment in the radiating element. The currents are strongest at the left hand side of the image and they become weaker moving towards the right hand side of the image. This is because a standing wave of voltage and current is formed on a resonating quarter wavelength monopole as charge is accelerated and decelerated along the element. The current falls to zero at the open circuit end of the radiating element and peaks at the feed while the reverse is true for the voltage which peaks at the open circuit end.

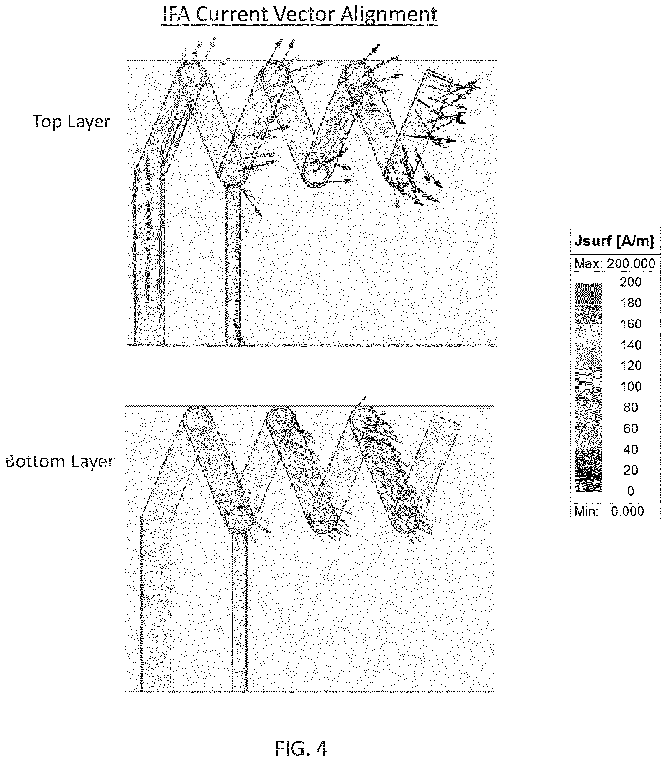

Figure 4 is a top and bottom layer view of an inverted-F antenna in accordance with an aspect of the present disclosure. Similarly to Figure 3, the top layer view shows the first conductive layer 201 in more detail and the bottom layer view shows the second conductive layer 202 in more detail, in particular, illustrating the current vector alignment in the radiating element. The currents are strongest at the left hand side of the image and they become weaker moving towards the right hand side of the image. This is because a standing wave of voltage and current is formed on a resonating quarter wavelength monopole as charge is accelerated and decelerated along the element. The current falls to zero at the open circuit end of the radiating element and peaks at the feed while the reverse is true for the voltage which peaks at the open circuit end.

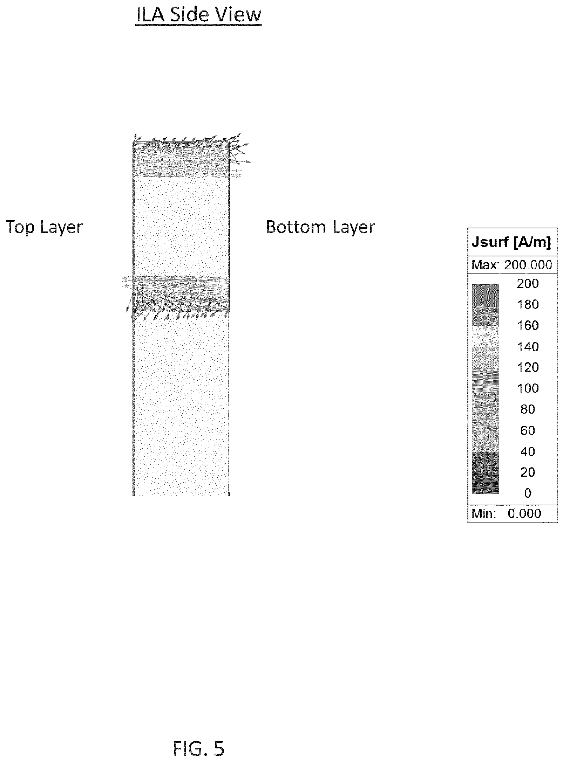

Figure 5 is a side view of an inverted-L antenna in accordance with an aspect of the present disclosure. The side view shows the current vectors between the first conductive layer 101 and the second conductive layer 102 in more details, in particular, illustrating the current vector alignment in the radiating element. The surface currents are strongest towards the centre of the coiled structure where the magnetic field generated as current flowing along the coiled element is strongest.

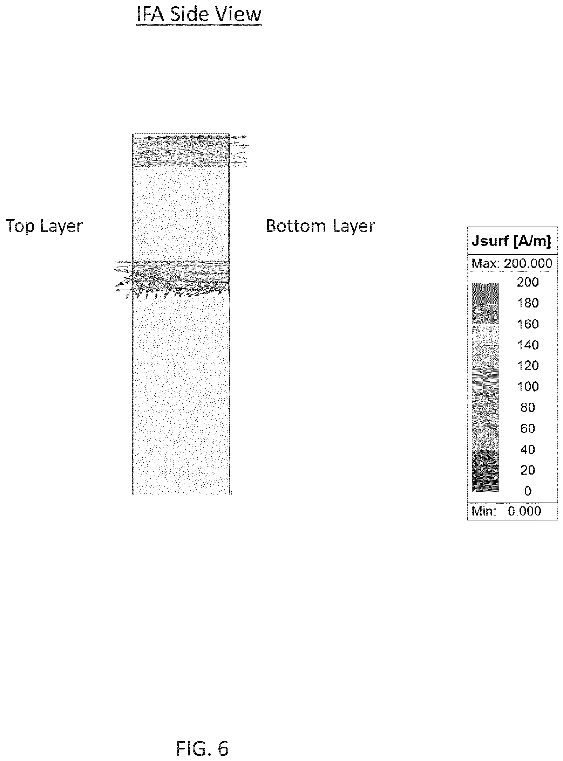

Figure 6 is a side view of an inverted-F antenna in accordance with an aspect of the present disclosure. Similarly to Figure 5, the side view shows the current vectors between the first conductive layer 201 and the second conductive layer 202 in more details, in particular, illustrating the current vector alignment in the radiating element. The surface currents are strongest towards the centre of the coiled structure where the magnetic field generated as current flowing along the coiled element is strongest.

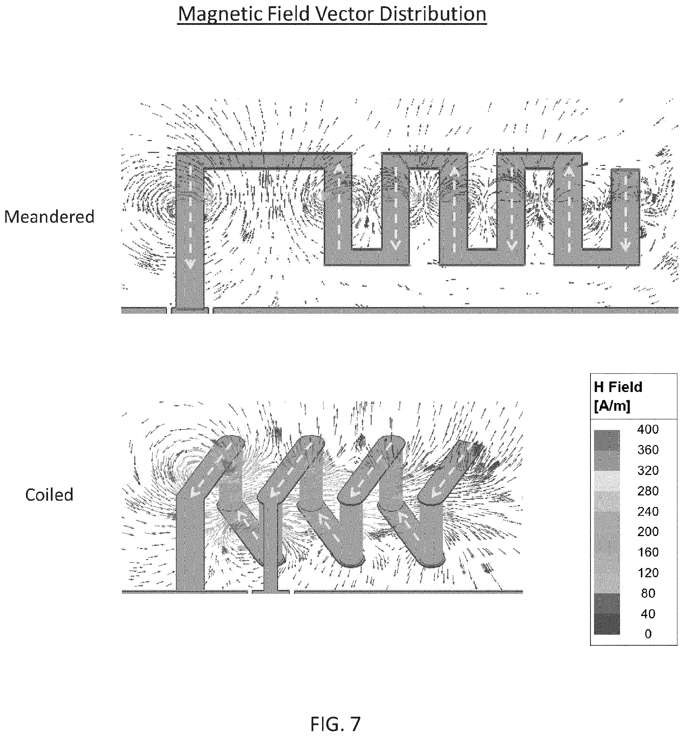

Figure 7 illustrates magnetic field distribution vectors on a plane perpendicular to the conductor layer for both meandered and coiled antenna structures. When current flows in a conductor a magnetic field, H-Field, is created around the conductor. The flow of the H-Field encircles the conductors following the right-hand rule with its flow direction determined by the current vector i.e. the direction of current flow along the conductor which is indicated by arrows in Figure 7. In the case of the meandered antenna, the current vectors of adjacent conductor sections are opposing resulting in opposing magnetic fields and opposing induced currents which in turn results in cancellation of magnetic fields and minimal radiation along these adjacent conductors. Instead, the majority of radiation occurs at the conductors joining the adjacent sections. This results in the decrease in the antennas effective length and the requirement for an increase in conductor length to return the antenna to its target frequency. In the case of the coiled structure, the current vectors are substantially aligned resulting in reinforcing of the magnetic field to a point where the fields of the individual conductors are superimposed creating stronger magnetic field lines flowing through the centre of the coil. Currents induced on adjacent conductors by the magnetic flow follow the right-hand rule and so are reinforcing enabling the target frequency to be achieved with a shorter length of conductor when compared to the meandered structure.

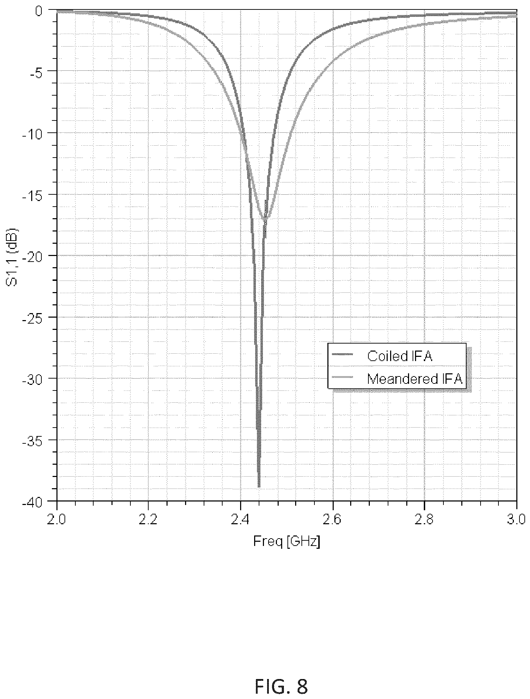

Figure 8 is an example graph of the reflection coefficient for different printed antennas in accordance with an aspect of the present disclosure. The 'Meandered IFA' line could demonstrate exemplary reflective coefficient value for the bottom example of Figure 1 and the 'Coiled IFA' line could demonstrate exemplary reflective coefficient values for the bottom example of Figure 2. The reflection coefficient represents how much power is reflected from the antenna. If the reflective coefficient is 0 dB, then all the power is reflected from the antenna and nothing is radiated. A typical performance metric is the bandwidth over which the antenna achieves a reflection coefficient below -10dB indicating that more that 90% of the power has been transmitted over that frequency band. It can be seen that the 'Meandered IFA' has a wider -10dB reflection coefficient bandwidth compared to the 'Coiled IFA' which is an expected result of using dielectric material to reduce antenna size.

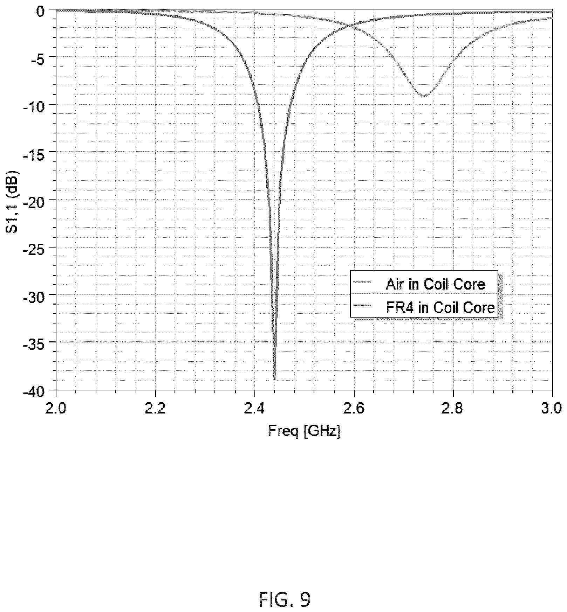

Figure 9 is an example graph of the reflective coefficient for different dielectrics in accordance with an aspect of the present disclosure. In the example of Figure 9, both the 'Air in Coil Core' and the 'FR4 in Coil Core' may relate to the bottom example of Figure 2. It can be seen that the 'Air in Coil Core' line has a resonant frequency of around 2.74 GHz, whereas the 'FR4 in Coil Core' line has a resonant frequency of around 2.44 GHz, which demonstrates that increasing the dielectric constant in the coil core from 1 to 4.4 resulted in a 300 MHz downshift in resonant frequency for a fixed conductor length.

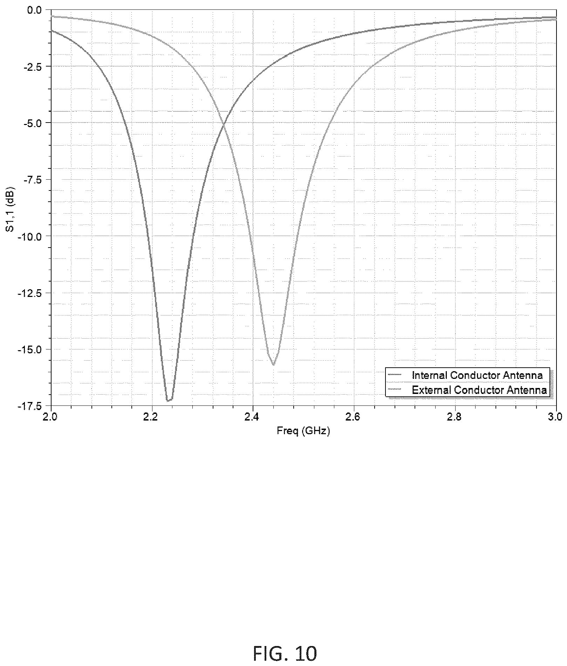

Figure 10 is an example graph of the reflective coefficient for different conductor layers in accordance with an aspect of the present disclosure. The 'External Conductor Antenna' demonstrates the reflective coefficient for an antenna whereby the antenna structure is formed on the two outermost conductive layers as illustrated in the bottom example of Figure 2. The 'Internal Conductor Antenna' example demonstrates an antenna with identical conductor dimensions to the 'External Conductor Antenna' example. However, additional substrate layers have been added above and below the conductive layers to demonstrate a configuration where the antenna is formed on internal conductive layers. A downshift of 200 MHz is observed which is a result of increasing the average dielectric constant in the area surrounding the antenna. This example illustrates the two extremes, and it follows that an antenna constructed on one outermost layer and one internal layer would result in an average dielectric constant between the examples and so would result in an operating frequency between the illustrated examples, and can be designed to have a desired operating frequency. It can be observed that manufacturing the antenna on internal layers can further reduce the length of conductor required to achieve a target operating frequency. However, this technique requires the use of blind or buried vias which increase fabrication costs as they add additional stages to the PCB fabrication.

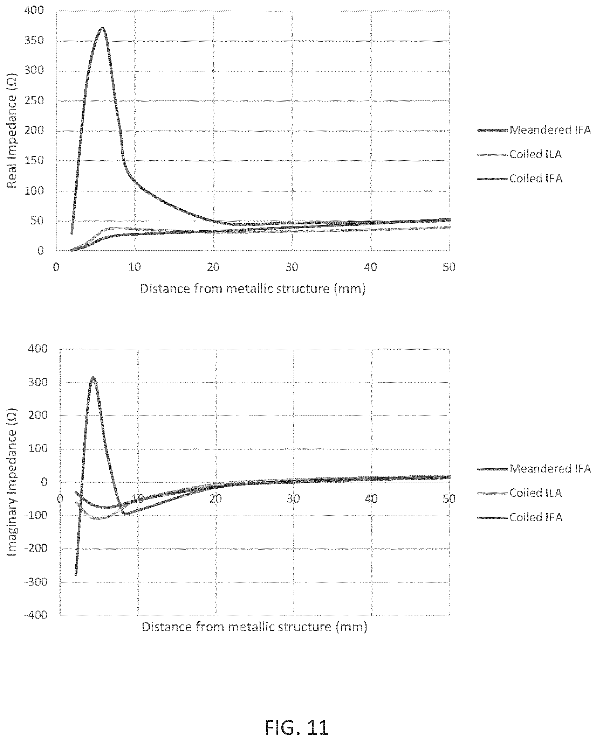

Figure 11 shows example graphs of the real and imaginary impedance of different antennas. The 'Meandered IFA' line could demonstrate exemplary real and imaginary impedance values for the bottom example of Figure 1, the 'Coiled ILA' line could demonstrate exemplary real and imaginary impedance values for the top example of Figure 2, and the 'Coiled IFA' line could demonstrate exemplary real and imaginary impedance values for the bottom example of Figure 2. It can be seen that the performance of the 'Coiled ILA' has the smallest peaks for both the real and imaginary parts. Preferably, input impedance should be close to 50+0i Ω, which is an industry standard compromise between power handling and low loss. Reduced variation from 50+0i Ω suggests the proposed antenna will be easier to re-tune to operate in close proximity to metallic object.

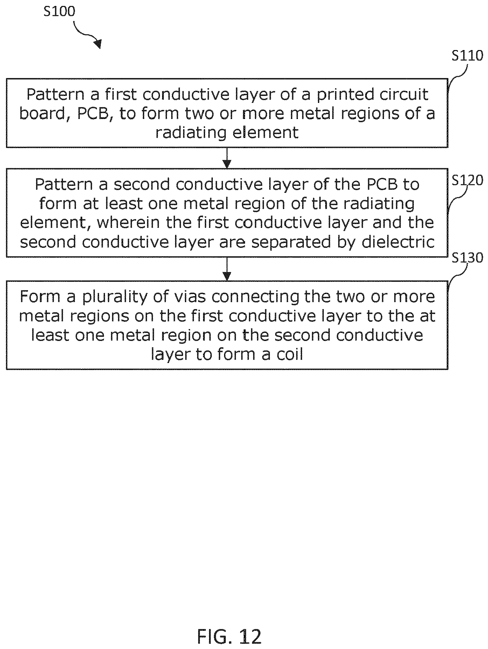

Figure 12 represents example method steps S100 according to an aspect of the present disclosure. At step S110, a first conductive layer of a printed circuit board, PCB, is patterned to form two or more metal regions of a radiating element. Then, at step S120, a second conductive layer of the PCB is patterned to form at least one metal region of the radiating element, wherein the first conductive layer and the second conductive layer are separated by dielectric. Finally, at step S130, a plurality of vias are formed connecting the two or more metal regions on the first conductive layer to the at least one metal region on the second conductive layer to form a coil. These steps may be performed using photolithographic techniques or other suitable manufacturing technology.

The skilled person will readily appreciate that various alterations or modifications may be made to the above described aspects of the disclosure without departing from the scope of the disclosure. For example, features of two or more of the above examples may be combined and still fall within the scope of the present disclosure.

### Numbered aspects

By way of non-limiting example, some aspects of the disclosure are set out in the following numbered clauses.

Numbered Clause 1. A printed circuit board (PCB) comprising:
a first conductive layer patterned to form two or more metal regions of a printed antenna;
a second conductive layer patterned to form at least one metal region of the printed antenna, wherein the first conductive layer and the second conductive layer are separated by dielectric; and
a plurality of vias connecting the two or more metal regions on the first conductive layer to the at least one metal region on the second conductive layer to form a coil.

Numbered Clause 2. The PCB of Numbered Clause 1, wherein the printed antenna is an inverted-L antenna.

Numbered Clause 3. The PCB of Numbered Clause 1 or 2, wherein the printed antenna is an inverted-F antenna.

Numbered Clause 4. The PCB of any preceding Numbered Clause, wherein a current vector of the printed antenna along the two or more metal regions is aligned.

Numbered Clause 5. The PCB of Numbered Clause 1, wherein the two or more metal regions on the first conductive layer comprises at least four metal regions, and wherein the one or more metal regions on the second conductive layer comprises at least three metal regions.

Numbered Clause 6. The PCB of any preceding Numbered Clause, wherein the two or more metal regions on the first conductive layer includes a first metal region connected to a radio frequency (RF) signal feed for the printed antenna.

Numbered Clause 7. The PCB of Numbered Clause 6, wherein the two or more metal regions on the first conductive layer further includes a second metal region connected to an impedance tuning structure.

Numbered Clause 8. The PCB of any preceding Numbered Clause, implemented in a battery module of a wireless battery management system.

Numbered Clause 9. The PCB of any preceding Numbered Clause, wherein the plurality of vias comprise a plurality of through-hole vias.

Numbered Clause 10. The PCB of any preceding Numbered Clause, wherein the first conductive layer and the second conductive layer are outermost conductive layers of the PCB.

Numbered Clause 11. The PCB of any preceding Numbered Clause, wherein the first conductive layer and the second conductive layer comprise copper layers.

Numbered Clause 12. A wireless battery management system comprising:
a battery module; and
a printed circuit board (PCB) coupled to the battery module, wherein the PCB comprises:
   a first conductive layer patterned to form two or more metal regions of a printed antenna;
   a second conductive layer patterned to form at least one metal region of the printed antenna, wherein the first conductive layer and the second conductive layer are separated by dielectric; and
   a plurality of vias connecting the two or more metal regions on the first conductive layer to the at least one metal region on the second conductive layer to form a coil.

Numbered Clause 13. The wireless battery management system of Numbered Clause 12, further comprising any combination of features of Numbered Clauses 2 through 11.

Numbered Clause 14. A method of antenna formation, the method comprising: patterning a first conductive layer of a printed circuit board (PCB) to form two or more metal regions of a printed antenna;
patterning a second conductive layer of the PCB to form at least one metal region of the printed antenna, wherein the first conductive layer and the second conductive layer are separated by dielectric; and
forming a plurality of vias connecting the two or more metal regions on the first conductive layer to the at least one metal region on the second conductive layer to form a coil.

Numbered Clause 15. The method of Numbered Clause 14, further comprising any combination of features of Numbered Clauses 2 through 11.

Numbered Clause 16. A printed antenna, comprising: a first conductive layer patterned to form two or more metal regions of a radiating element; a second conductive layer patterned to form at least one metal region of the radiating element, wherein the first conductive layer and the second conductive layer are separated by a dielectric; and a plurality of vias connecting the two or more metal regions on the first conductive layer to the at least one metal region on the second conductive layer to form a coil.

Numbered Clause 17. The printed antenna of Numbered Clause 16, wherein the two or more metal regions on the first conductive layer are arranged at an angle relative to the at least one region on the second conductive layer.

Numbered Clause 18. The printed antenna of Numbered Clause 16 or 17, wherein the two or more metal regions on the first conductive layer are arranged substantially in parallel with one another.

Numbered Clause 19. The printed antenna of any of Numbered Clauses 16 to 18, wherein the two or more metal regions on the first conductive layer are arranged such that a current vector of the printed antenna along the two or more metal regions on the first conductive layer is aligned.

Numbered Clause 20. The printed antenna of any of Numbered Clauses 16 to 19, wherein the second conductive layer comprises two or more metal regions arranged substantially in parallel with one another.

Numbered Clause 21. The printed antenna of Numbered Clause 20, wherein the two or more metal regions on the second conductive layer are arranged such that a current vector of the printed antenna along the two or more metal regions on the second conductive layer is aligned.

Numbered Clause 22. The printed antenna of any of Numbered Clauses 16 to 21, wherein the printed antenna comprises further conductive layers having metal regions that are substantially in parallel with one another but substantially not in parallel with the metal regions on the other conductive layers.

Numbered Clause 23. The printed antenna of any of Numbered Clauses 16 to 22, wherein the two or more metal regions on the first conductive layer includes a first metal region electrically coupled to a radio frequency, RF, signal feed for the printed antenna and/or a second metal region electrically coupled to an impedance tuning structure.

Numbered Clause 24. The printed antenna of any of Numbered Clauses 16 to 23, wherein the dielectric separating the first conductive layer and the second conductive layer is configured to reduce a resonant frequency of the printed antenna.

Numbered Clause 25. The printed antenna of any of Numbered Clauses 16 to 24, wherein the plurality of vias are through-hole vias.

Numbered Clause 26. The printed antenna of any of Numbered Clauses 16 to 25, wherein the first conductive layer and the second conductive layer comprise copper metallisation.

Numbered Clause 27. The printed antenna of any of Numbered Clauses 16 to 26, configured to be implemented in a battery module of a wireless battery management system.

Numbered Clause 28. The printed antenna of any of Numbered Clauses 16 to 27, wherein the first conductive layer and the second conductive layer are layers of a printed circuit board, PCB

Numbered Clause 29. The printed antenna of any of Numbered Clauses 16 to 28, wherein at least one of the first conductive layer and the second conductive layer is an outermost conductive layer of the printed antenna.

Numbered Clause 30. The printed antenna of any of Numbered Clauses 16 to 29, wherein at least one of the first conductive layer and the second conductive layer is an internal conductive layer of the printed antenna.

Numbered Clause 31. The printed antenna of any of Numbered Clauses 16 to 30, wherein one of the first conductive layer and the second conductive layer is an outermost conductive layer of the printed antenna and the other of the first conductive layer and the second conductive layer is an internal conductive layer of the printed antenna.

Numbered Clause 32. The printed antenna of any of Numbered Clauses 16 to 31, wherein the printed antenna is an inverted-L antenna

Numbered Clause 33. The printed antenna of any of Numbered Clauses 16 to 32, wherein the printed antenna is an inverted-F antenna.

Numbered Clause 34. A wireless battery management system comprising: a battery module; and a printed antenna according to any preceding claim coupled to the battery module.

Numbered Clause 35. A method of forming a printed antenna, the method comprising: patterning a first conductive layer of a printed circuit board, PCB, to form two or more metal regions of a radiating element; patterning a second conductive layer of the PCB to form at least one metal region of the radiating element, wherein the first conductive layer and the second conductive layer are separated by dielectric; and forming a plurality of vias connecting the two or more metal regions on the first conductive layer to the at least one metal region on the second conductive layer to form a coil.

## Claims

1. A printed antenna, comprising:
a first conductive layer patterned to form two or more metal regions of a radiating element;
a second conductive layer patterned to form at least one metal region of the radiating element, wherein the first conductive layer and the second conductive layer are separated by a dielectric; and
a plurality of vias connecting the two or more metal regions on the first conductive layer to the at least one metal region on the second conductive layer to form a coil.

2. The printed antenna of claim 1, wherein the two or more metal regions on the first conductive layer are arranged at an angle relative to the at least one region on the second conductive layer.

3. The printed antenna of claim 1 or 2, wherein the two or more metal regions on the first conductive layer are arranged substantially in parallel with one another.

4. The printed antenna of any preceding claim, wherein the two or more metal regions on the first conductive layer are arranged such that a current vector of the printed antenna along the two or more metal regions on the first conductive layer is aligned.

5. The printed antenna of any preceding claim, wherein the second conductive layer comprises two or more metal regions arranged substantially in parallel with one another.

6. The printed antenna of claim 5, wherein the two or more metal regions on the second conductive layer are arranged such that a current vector of the printed antenna along the two or more metal regions on the second conductive layer is aligned.

7. The printed antenna of any preceding claim, wherein the printed antenna comprises further conductive layers having metal regions that are substantially in parallel with one another but substantially not in parallel with the metal regions on the other conductive layers.

8. The printed antenna of any preceding claim, wherein the two or more metal regions on the first conductive layer includes a first metal region electrically coupled to a radio frequency, RF, signal feed for the printed antenna and/or a second metal region electrically coupled to an impedance tuning structure.

9. The printed antenna of any preceding claim, wherein the dielectric separating the first conductive layer and the second conductive layer is configured to reduce a resonant frequency of the printed antenna.

10. The printed antenna of any preceding claim, wherein at least one of the first conductive layer and the second conductive layer is an outermost conductive layer of the printed antenna.

11. The printed antenna of any preceding claim, wherein at least one of the first conductive layer and the second conductive layer is an internal conductive layer of the printed antenna.

12. The printed antenna of any preceding claim, wherein one of the first conductive layer and the second conductive layer is an outermost conductive layer of the printed antenna and the other of the first conductive layer and the second conductive layer is an internal conductive layer of the printed antenna.

13. The printed antenna of any preceding claim, wherein the printed antenna is an inverted-L antenna or wherein the printed antenna is an inverted-F antenna.

14. A wireless battery management system comprising:
a battery module; and
a printed antenna according to any preceding claim coupled to the battery module.

15. A method of forming a printed antenna, the method comprising:
patterning a first conductive layer of a printed circuit board, PCB, to form two or more metal regions of a radiating element;
patterning a second conductive layer of the PCB to form at least one metal region of the radiating element, wherein the first conductive layer and the second conductive layer are separated by dielectric; and
forming a plurality of vias connecting the two or more metal regions on the first conductive layer to the at least one metal region on the second conductive layer to form a coil.
